Europäisches Patentamt

European Patent Office

Office européen des brevets

(11) Veröffentlichungsnummer: **0 465 793 A2**

# (12) EUROPÄISCHE PATENTANMELDUNG

(21) Anmeldenummer: **91107560.4**

(22) Anmeldetag: **09.05.91**

(51) Int. Cl.5: **G06F 11/22**, G05B 9/00, G05B 23/00

(30) Priorität: **09.07.90 DE 4021840**

(43) Veröffentlichungstag der Anmeldung:
**15.01.92 Patentblatt 92/03**

(84) Benannte Vertragsstaaten:
**CH FR GB IT LI SE**

(71) Anmelder: **MERCEDES BENZ AG**
**Mercedesstrasse 136**
**W-7000 Stuttgart 60(DE)**

(72) Erfinder: **Forchert, Thomas**
**Wildungerstrasse 74**
**W-7000 Stuttgart 50(DE)**
Erfinder: **Visel, Ulrich**
**Reyherstrasse 12**
**W-7302 Ostfildern 4(DE)**

(54) **Mehrrechnersystem für Steuer- und Diagnosegeräte bei einem Kraftfahrzeug.**

(57) Ein Master-Slave-Mehrrechnersystem für Steuer- und Diagnosegeräte bei einem Kraftfahrzeug wird beschrieben. Das Mehrrechnersystem nutzt für die getrennte oder wahlweise zeitgleich übergreifende Abarbeitung verschiedener Programme nur ein ROM-Element, das leicht ausgetauscht werden kann, oder ein RAM-Element, dessen Inhalt über eine Schnittstelle neu geladen oder überschrieben werden kann. Die sich daraus ergebende Systemstruktur erlaubt auch die wahlfreie Verwendung wenigstens eines Slave-Prozessors für beliebig unterschiedliche bzw. auswechselbare Aufgaben, indem sein Speicherbereich in schnellem Zugriff vonseiten eines Master-Prozessors nach Maßgabe des RAM- oder ROM-Inhalts modifizierbar bzw. überschreibbar ist.

Fig. 1

EP 0 465 793 A2

Die Erfindung betrifft ein Mehrrechnersystem für Steuer- und Diagnosegeräte bei einem Kraftfahrzeug nach dem Gattungsbegriff des Anspruchs 1.

Die zunehmende Zahl elektronischer Systeme und deren zunehmende Komplexität bedingt einen wachsenden Bedarf an Zwei- bzw. Mehrrechnersystemen im Kraftfahrzeug, etwa für die parallele Abarbeitung zeitkritischer Prozesse wie z.B. in Bremsanlagen oder sonstigen sicherheitswesentlichen Systemen, aber auch in Diagnose-Systemen für Kraftfahrzeuge.

Problematisch bei solchen Zwei- oder Mehrrechnersystemen ist, wenn ihnen beispielsweise für Anwendungen in verschiedenen Ländern aufgrund abweichender Sicherheitsvorschriften unterschiedliche Parameter- oder Festwertsätze zugeordnet werden sollen, oder aber auch ganze Programmteile einfach und zuverlässig austauschbar sein sollen. Es müssen dann wenigstens zwei, meist aber noch mehr ROM-Bausteine ausgetauscht werden. Entsprechende Bausteine verursachen einen gewissen Lageraufwand, und da mehrere solcher Bausteine vorgesehen werden müssen, sind Verwechslungen oder ein versehentlich paarweises Bestücken von nicht zusammenpassenden oder -gehörenden ROM-Bausteinen nicht ausgeschlossen. Auch ist es möglich, daß im Zuge der technischen Weiterentwicklung der Inhalt z.B. eines ROM-Bausteins Modifikationen erfährt, die entsprechende Modifikationen anderer ROM-Bausteine verlangen. Beim Tausch des Arbeits-ROMs eines Rechners muß deshalb dafür Sorge getragen werden, daS die Inhalte nicht getauschter ROMs kompatibel bzw. verträglich mit dem Inhalt des getauschten ROMs sind. Ein entsprechender logistischer Aufwand ist offensichtlich.

Es ist Aufgabe der Erfindung, ein Mehrrechnersystem für Steuer- und Diagnosegeräte bei einem Kraftfahrzeug zu schaffen, bei welchem in möglichst einfacher und sicherer Weise Festwerte, Parameter oder Programmteile für wenigstens einen der mehreren Rechner mit geringem logistischem Aufwand austauschbar sind.

Diese Aufgabe wird bei einem gattungsgemäßen Mehrrechnersystem mit den Merkmalen des Anspruchs 1 gelöst.

Das erfindungsgemäße Mehrrechnersystem besitzt eine an sich bekannte Master-Slave-Konfiguration und weist zudem den Vorteil auf, nur einen einzigen ROM-Baustein zu benötigen, der insoweit verwechslungsfrei ausgetauscht werden kann, so daß nur jeweils zusammenpassende bzw. miteinander verträgliche Datensätze bzw. Programmteile für alle Rechner zwangsläufig bestückbar sind. Dadurch werden Fehlermöglichkeiten und der logistische Aufwand für den Service bzw. die Anpassung von Geräten, die solche Mehrrechnersysteme enthalten, auf ein Mindestmaß reduziert.

Vorteilhafte Fortbildungen sind nach der Lehre der abhängigen Ansprüche 2 bis 9 gegeben. So erlaubt das erfindungsgemäße System beispielsweise, den Slave-Rechner wahlfrei für beliebige, gänzlich unterschiedliche Aufgaben einzusetzen, und den entsprechenden Wechsel selbst großer Programme sehr schnell vorzunehmen.

Zwei Ausführungsbeispiele der Erfindung sind in der Zeichnung dargestellt und nachfolgend erläutert. Es zeigen:

Figur 1 das Blockschaltbild eines erfindungsgemäßen Master-Slave-Zweirechnersystems mit nur einem ROM, angewandt auf ein Diagnosegerät;

Figur 2 das Blockschaltbild eines entsprechenden Master-Slave-Zweirechnersystems, in welchem der Slave-Prozessor über keine ausschließlich ihm zur Verfügung stehende Speichermittel mehr verfügt.

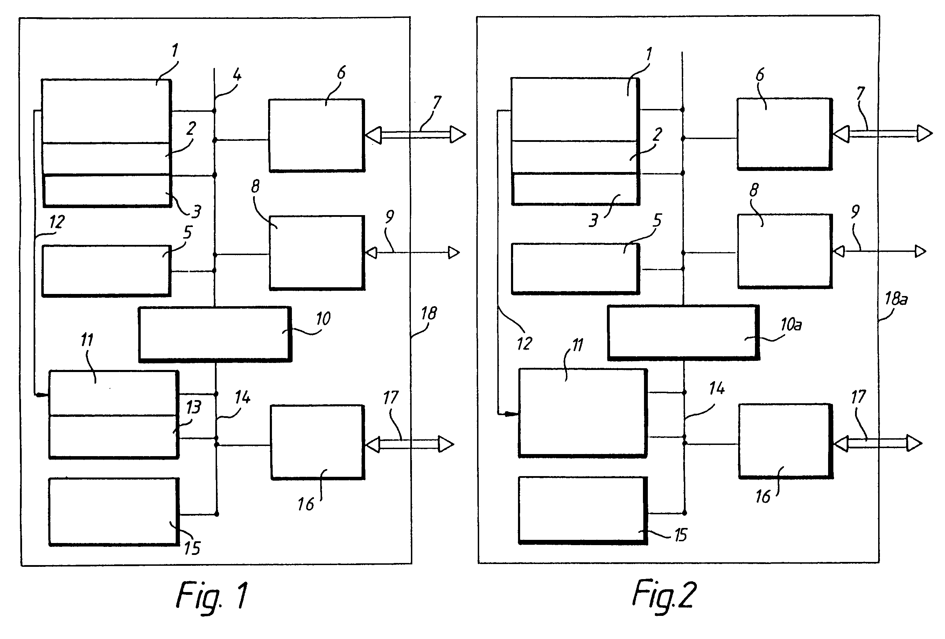

Am Beispiel eines Diagnosegerätes 18 wird das erfindungsgemäße Mehrrechnersystem anhand der **Figur 1** erläutert.

Einem Master-Prozessor 1 sind ein RAM-Bereich 2 und ein beispielsweise mittels eines hier nicht dargestellten Stecksockels oder Chip-Carriers austauschbarer ROM-Bereich 3 zugeordnet. Sowohl der Master-Prozessor als auch besagte RAM/ROM-Bereiche liegen an einem mit Adressen und Daten beaufschlagbaren Master-Systembus 4, der an eines der beiden Tore eines zusätzlichen Zwei-Tor-RAMs 10 geführt ist. Eine Systemuhr 5 ist ebenfalls an den Bus 4 geführt. Mit besagtem Bus 4 stehen auch noch eine erste Schnittstelle 6 und Eingabe- und Anzeigemittel 8 in Verbindung. Die erste Schnittstelle kann über einen Datenpfad mit der Systemumgebung, beispielsweise mit einem Werkstattrechner, kommunizieren. Auf die Eingabe- und Anzeigemittel 8 nimmt der Bediener Einfluß 9.

Einem Slave-Prozessor 11 ist ein RAM-Bereich 13 zugeordnet. Der Slave-Prozessor 11 und der RAM-Bereich 13 sind mit einem entsprechenden Slave-System-Bus 14 verbunden, welcher an das zweite Tor des besagten Zwei-Tor-RAMs 10 geführt ist, d.h. über das Zwei-Tor-RAM 10 mit dem Master-System-Bus 4 kommuniziert. Außerdem liegen am Slave-System-Bus 14 noch ein Funktionsblock zur Baudratenmessung und -erzeugung 15, z.B. ein Baudraten-Controller, und eine zweite Schnittstelle 16, wobei letztere über einen Datenpfad 17 mit Einrichtungen in einem Kraftfahrzeug, beispielsweise mit Steuergeräten, zu kommunizieren vermag. Über eine Verbindung 12 stehen der Master-Prozessor 1 und der Slave-Prozessor 11 unmittelbar in Verbindung miteinander.

Das vorbeschriebene System funktioniert wie folgt.

Die im Slave-Prozessor 11 abzuarbeitenden Programme sind im ROM 3 oder RAM 2 entweder als solche enthalten oder aber gemäß dem für den Master-Prozessor 1 dort gespeicherten Programm aus ebendort abgelegten Elementen je nach Bedarf generierbar. Über die erste Schnittstelle 6 können mittels eines im ROM-Bereich 3 abgespeicherten Programms ("Boot-Programm") Festwerte, Parameter und/oder Programmteile aller Prozessoren in den RAM-Bereich 2 geladen werden. Der Slave-Prozessor 11 sieht also keinen eigenen residenten ROM-Speicher.

Nach Initialisierung wird in diesem Sinne das im Slave-Prozessor 11 abzuarbeitende Programm aus dem ROM-Bereich 3 oder dem RAM-Bereich 2 vom Master-Prozessor 1 in das Zwei-Tor-RAM 10 geladen. Der Slave-Prozessor 11 startet nach einem über die Verbindung 12 vom Master-Prozessor 1 empfangenen Reset-Signal mit der Abarbeitung seines Programms aus dem Zwei-Tor-RAM 10. Größere Programme können vom Slave-Prozessor 11 aus dem Zwei-Tor-RAM 10 in den separaten RAM-Bereich 13 geladen und von dort aus ausgeführt werden.

Im beispielhaft angenommenen Anwendungsfall eines Diagnosetesters für ein Kraftfahrzeug bedeutet dies, daß der Diagnosetester durch Wechsel des ROMs an neue Prüfprotokolle bzw. Prüfwerte vollständig angepaßt werden kann. Auf der anderen Seite ist das System in der Lege, eine parallele Abarbeitung zeitkritischer Prozesse zu leisten, so etwa die Acquisition von Eingaben des Bedieners, die Verarbeitung von Meßwerten und die Darstellung von Daten im Master-Prozessor 1 einerseits und die Kommunikation mit Elektronikeinheiten in einem Fahrzeug über den Slave-Prozessor 11 andererseits.

Im Diagnosegerätes 18a gemäß **Figur 2** ist für den Slave-Prozessor 11 kein eigener RAM-Bereich mehr vorgesehen. Vielmehr ist der RAM-Bereich des Slave-Prozessors in das - mit dementsprechend großer Speicherkapazität ausgebildete - Zwei-Tor-RAM 10a integriert; alle in einem bestimmten Augenblick jeweils relevanten Programmzellen des Slave-Prozessors befinden sich also immer in unmittelbarem Zugriff vonseiten des Master-Systembusses 4.

Für die grundsätzlich gleiche Funktion folgt aus dieser Maßnahme eine schnellere Änderbarkeit von solchen Festwerten und Parametern sowie eine schnellere Abwickelbarkeit von solchen Programmteilen, auf die beide Prozessoren im Quasi-Parallelbetrieb zugreifen. Der Slave-Prozessor 11 hat insoweit durch vollständige Auslagerung seines eigenen RAM-Bereichs in das Zwei-Tor-RAM 10a, welches als bidirektionale, die System-Busse 4 und 14 koppelnde Inter-Prozessor-Schnittstelle wirkt, besonders schnellen Zugriff auf alle Daten und Programmteile des Master-Rechnersystems.

Selbstverständlich ist der Erfindungsgedanke auch auf Mehrrechnersysteme, die mehr als zwei Prozessoren enthalten, übertragbar und insoweit von der Erfindung mitumfaßt. In jedem Falle nutzt das Mehrrechnersystem für die getrennte oder wahlweise zeitgleich übergreifende Abarbeitung verschiedener Programme nur ein ROM-Element, das leicht ausgetauscht werden kann, oder ein RAM-Element, dessen Inhalt über eine Schnittstelle neu galden oder überschrieben werden kann. Die sich daraus ergebende Systemstruktur wie oben beschrieben erlaubt auch die wahlfreie Verwendung wenigstens eines Slave-Prozessors für beliebig unterschiedliche und auswechselbare Aufgaben, indem der Speicherbereich des wenigstens einen Slave-Prozessors in schnellem Zugriff vonseiten eines Master-Prozessors nach Maßgabe des Inhalts des einen ROM- oder RAM Elements modifizierbar bzw. überschreibbar ist.

Ohne Beschränkung der Allgemeinheit ist das anhand des Beispiels eines Diagnosegerätes beschriebene Mehrrechnersystem auch in Steuerund Regelgeräten für Kraftfahrzeuge anwendbar, so daß der Rahmen der Erfindung nicht verlassen wird, wenn das erfindungsgemäße Mehrrechnersystem eine Implementation in beliebigen Komponenten eines Kraftfahrzeugs erfährt.

**Patentansprüche**

1. Mehrrechnersystem für Steuer- und Diagnosegeräte bei einem Kraftfahrzeug, mit einem Master-Prozessor (1) und wenigstens einem Slave-Prozessor (11) und diesen zugeordneten RAM-Bereichen (2; 13 bzw. 10, 10a) und mit einem als Inter-Prozessor-Schnittstelle fungierenden Zwei-Tor-RAM (10, 10a), wobei der Master-Prozessor (1) und ihm zugeordnete Speichermittel mit dem ersten Tor besagten Zwei-Tor-RAMs (10, 10a) durch einen ersten Daten- und Adress-Bus (4) und der wenigstens eine Slave-Prozessor (11) durch einen zweiten Daten- und Adressbus (14) mit dem zweiten Tor besagten Zwei-Tor-RAMs (10, 10a) verbunden sind,
   **dadurch gekennzeichnet**,
   - daß nur ein einziger, dem Master-Prozessor (1) zugeordneter ROM-Bereich (3) vorgesehen ist, und
   - daß mittels eines im ROM-Bereich (3) abgespeicherten Programms des Master-Prozessors (1) das Betriebsprogramm des wenigstens einen Slave-Prozessors (11) in einen RAM-Bereich (10, 10a; 13) des wenigstens einen Slave-Prozessors (11) ladbar ist, und

- daß nach Rücksetzen des Slave-Prozessors (11) durch den Master-Prozessor (1) das Betriebsprogramm des wenigstens einen Slave-Prozessors (11) aus dessen RAM-Bereich abarbeitbar ist.

2. Mehrrechnersystem nach Anspruch 1,
**dadurch gekennzeichnet**,
- daß mittels besagten im ROM-Bereich (3) abgespeicherten Programms für den Master-Prozessor (1) über eine Schnittstelle (6) in den RAM-Bereich (2) des Master-Prozessors (1) das Betriebsprogramm für den Master- (1) und den wenigstens einen Slave-Prozessor (11) ladbar ist, und
- daß mittels des im RAM-Bereich (2) des Master-Prozessors (1) abgespeicherten Betriebsprogramms des Master-Prozessors (1) das Betriebsprogramm des wenigstens einen Slave-Prozessors (11) in einen RAM-Bereich (10, 10a; 123) desselben ladbar ist.

3. Mehrrechnersystem nach Anspruch 1,
**dadurch gekennzeichnet**,
- daß besagter ROM-Bereich gesockelt bzw. in sonst geeigneter Weise leicht austauschbar vorgesehen bzw. ausgebildet ist.

4. Mehrrechnersystem nach Anspruch 1,
**dadurch gekennzeichnet**,
- daß der RAM-Bereich des wenigstens einen Slave-Prozessors (11) ausschließlich aus dem mit dem Master-Prozessor busgekoppelten Zwei-Tor RAM (10a) besteht.

5. Mehrrechnersystem nach Anspruch 1,
**dadurch gekennzeichnet**,
- daß der RAM-Bereich des wenigstens einen Slave-Prozessors (11) zum Teil aus dem mit dem Master-Prozessor (1) busgekoppelten Zwei-Tor RAM (10) und zum Teil aus einem separaten RAM-Bereich (13) besteht.

6. Mehrrechnersystem nach Anspruch 1,
**dadurch gekennzeichnet**,
- daß das Programm des wenigstens einen Slave-Prozessors (11) unmittelbar aus dem ROM-Bereich (3) des Master-Prozessors (1) in den RAM-Bereich (10, 10a; 13) des wenigstens einen Slave-Prozessors (11) ladbar ist.

7. Mehrrechnersystem nach Anspruch 1,

**dadurch gekennzeichnet**,
- daß das Betriebsprogramm für den Master-Prozessor (1) und den wenigstens einen Slave-Prozessor (11) über eine Schnittstelle (6) in den RAM-Bereich (2) des Master-Prozessors (1) ladbar ist.

8. Mehrrechnersystem nach Anspruch 1,
**dadurch gekennzeichnet**,
- daß das Programm des wenigstens einen Slave-Prozessors (11) unmittelbar aus dem RAM-Bereich (2) des Master-Prozessors (1) in den RAM-Bereich (10, 10a; 13) des wenigstens einen Slave-Prozessors (11) ladbar ist.

9. Mehrrechnersystem nach Anspruch 1,
**dadurch gekennzeichnet**,
- daß das Programm des wenigstens einen Slave-Prozessors (11) durch das Betriebsprogramm des Master-Prozessors (1) auf der Grundlage von ROM-gespeicherten Dateien generierbar und in den RAM-Bereich (10, 10a; 13) des wenigstens einen Slave-Prozessors (11) ladbar ist.

10. Mehrrechnersystem nach Anspruch 1,
**dadurch gekennzeichnet**,
- daß mit besagtem ersten Daten- und Adress-Bus (4) eine erste Schnittstelle (6) zu einer Systemumgebung sowie eine Bedieneinheit mit Display (8) und mit besagtem zweiten Daten- und Adress-Bus (14) eine zweite Schnittstelle (6) zu Steuereinrichtungen im Fahrzeug verbunden ist.

11. Mehrrechnersystem nach Anspruch 1,
**dadurch gekennzeichnet**,
- daß mit besagtem ersten Daten- und Adress-Bus (4) eine Echtzeit-Uhr (5) und mit besagtem zweiten Daten- und Adress-Bus (14) ein Baudraten-Controller (15) verbunden ist.

12. Mehrrechnersystem nach Ansprüchen 10 und 11,
**dadurch gekennzeichnet**,
- daß das Mehrrechnersystem Bestandteil eines mobilen bzw. tragbaren Diagnosetesters zur Überprüfung von elektrischen und elektronischen Ausrüstungskomponenten eines Kraftfahrzeugs ist.

Fig. 1

Fig.2

EP 0 465 793 A2